# FASCICULE DE BREVET EUROPEEN

(11) **EP 3 245 686 B1**
(45) Date de publication et mention de la délivrance du brevet: **17.10.2018**
(21) Numéro de dépôt: 15821149.0
(22) Date de dépôt: 16.12.2015
(51) Int. Cl.: H01M 10/48, H01M 10/42, G01R 31/36, B60L 11/18

(54) **SYSTÈME DE BATTERIES D'ACCUMULATEURS AVEC MESURE DE TENSION À CONSOMMATION REDUITE**
AKKUMULATORSYSTEM MIT MESSUNG VON NIEDRIGVERBRAUCHSSPANNUNG
STORAGE BATTERY SYSTEM WITH LOW CONSUMPTION VOLTAGE MEASUREMENT

(30) Priorité: 13.01.2015 FR 1550224
(43) Date de publication de la demande: 22.11.2017
(73) Titulaire: Renault S.A.S., 92100 Boulogne-Billancourt (FR)
(72) Inventeur: PALMIERI, Michaël, 38610 Gieres (FR); DERBEY, Alexis, 38420 Revel (FR); RANIERI, Marco, 38610 Gieres (FR); DANG VAN NHAN, Christophe, 94800 Villejuif (FR)
(74) Mandataire: GIE Innovation Competence Group
(86) Numéro de dépôt international: PCT/FR2015/053556
(87) Numéro de publication internationale: WO 2016/113479

(56) Documents cités:
- EP-A2- 1 067 393
- EP-A2- 1 933 443
- EP-A2- 1 967 408
- EP-A2- 2 783 905
- WO-A1-00/05596
- US-A1- 2008 180 106

## Description

L'invention concerne les batteries d'accumulateurs électrochimiques. Celles-ci peuvent par exemple être utilisées dans le domaine des transports électriques et hybrides ou les systèmes embarqués.

Un accumulateur électrochimique a habituellement une tension nominale de l'ordre de grandeur suivant:
1.2 V pour des batteries de type NiMH,
3.3 V pour une technologie Lithium ion phosphate de fer, LiFePO4,
3.7 V pour une technologie de type Lithium ion à base d'oxyde de cobalt ou à base de manganèse.

Ces tensions nominales sont trop faibles par rapport aux exigences de la plupart des systèmes à alimenter. Pour obtenir le niveau de tension adéquat, on place en série plusieurs accumulateurs. Pour obtenir de fortes puissances et capacités, on place plusieurs groupes d'accumulateurs en série. Le nombre d'étages et le nombre d'accumulateurs en parallèle dans chaque étage varient en fonction de la tension, du courant et de la capacité souhaités pour la batterie. L'association de plusieurs accumulateurs est appelée une batterie d'accumulateurs.

La plage de fonctionnement d'un accumulateur de type Li - ion à base d'oxyde de cobalt est typiquement comprise entre 2,7 V et 4,2 V. Une utilisation hors de cette plage peut induire une détérioration irréversible des accumulateurs de la batterie. Une tension inférieure à la plage d'utilisation induit la détérioration de la cellule. Une surcharge peut conduire à une destruction d'un accumulateur, à son usure accélérée, ou à une explosion par un phénomène d'emballement thermique. Une surveillance des accumulateurs est donc indispensable pour garantir à la fois la sécurité des utilisateurs et la durée de vie des batteries.

Selon une architecture de surveillance connue, des dispositifs de contrôle respectifs surveillent ainsi le niveau de potentiel de chaque étage. Chacun de ces dispositifs de contrôle est accolé à un étage et est généralement alimenté par cet étage. Chaque dispositif de contrôle communique avec une unité centrale pour lui fournir le niveau de potentiel mesuré pour son étage. L'unité centrale génère des commandes d'interruption de charge ou de décharge, en fonction des niveaux de potentiel reçus pour chaque étage.

La charge de tous les étages est par exemple interrompue lorsque l'étage le plus chargé atteint une limite haute de la plage de fonctionnement. Le potentiel de l'étage le moins chargé est alors égal à un potentiel inférieur à la limite haute.

L'unité centrale commande également l'interruption de la décharge de la batterie lorsque l'étage le moins chargé atteint une limite basse de la plage de fonctionnement.

Avec une alimentation des dispositifs de contrôle par les étages à contrôler, la consommation électrique des dispositifs de contrôle affecte l'autonomie fournie par la batterie. Ceci est particulièrement gênant pendant les phases de stockage prolongé de la batterie, l'autonomie de la batterie pouvant être fortement réduite au moment de son utilisation par rapport à ce qui est attendu.

Il a été proposé de placer les dispositifs de contrôle dans des modes de veille mais de tels modes ne sont pas disponibles pour toutes les technologies de dispositifs de contrôle, et les modes de veille induisent tout de même une consommation résiduelle.

Le document EP1967408 décrit un système de contrôle pour une batterie d'accumulateurs connectés en série. Chaque module comporte son propre contrôleur qui lui est connecté au module qu'il alimente. Chaque contrôleur comporte une interface d'entrée et une interface de sortie, connectées a des contrôleurs adjacents. Chaque contrôleur mesure différentes tensions de cellules à l'intérieur d'un module. Les mesures sont codées selon une séquence numérique pour leur transmission.

Le document US2008/0180106 décrit un système de contrôle pour une batterie d'accumulateurs connectes en série. Chaque module comporte son propre contrôleur qui lui est connecté et qu'il alimente. Chaque contrôleur comporte une interface d'entrée et une interface de sortie, connectées à des contrôleurs adjacents. Des mesures sont codées selon une séquence numérique pour leur transmission.

Le document EP1933443 décrit un système de contrôle pour une batterie d'accumulateurs connectes en série. Chaque module comporte son propre contrôleur qui lui est connecté et qu'il alimente. Chaque contrôleur comporte une interface d'entrée et une interface de sortie, connectées à des contrôleurs adjacents. Des mesures sont codées selon une séquence numérique pour leur transmission.

L'invention vise à résoudre cet inconvénient. L'invention porte ainsi sur un système de batterie d'accumulateurs, comprenant :
- des premier et deuxième étages d'accumulateurs électrochimiques connectés en série ;
- un premier dispositif de contrôle alimenté par l'intermédiaire des potentiels aux bornes d'au moins un accumulateur du premier étage, configuré pour mesurer la différence de potentiel aux bornes dudit premier étage, comprenant une première interface de sortie et une première interface d'entrée ;
- un deuxième dispositif de contrôle alimenté par l'intermédiaire des potentiels aux bornes d'au moins un accumulateur du deuxième étage, configuré pour mesurer la différence de potentiel aux bornes dudit deuxième étage, comprenant une deuxième interface de sortie, le deuxième dispositif de contrôle étant configuré pour appliquer, sur ladite deuxième interface de sortie, une séquence numérique codant la différence de potentiel mesurée par le deuxième dispositif de contrôle ;
- un circuit de communication par l'intermédiaire duquel la deuxième interface de sortie communique avec ladite première interface d'entrée ;
- un premier circuit d'alimentation incluant un interrupteur commandé appliquant ou coupant sélectivement l'alimentation dudit premier dispositif de contrôle, une interface de commande de l'interrupteur étant connectée à un noeud du circuit de communication de sorte que le maintien d'au moins un niveau logique sur ladite deuxième interface de sortie implique l'application de ladite alimentation sur ledit premier dispositif de contrôle;
- au moins un circuit de commande configuré pour commander sélectivement la coupure de l'alimentation dudit premier dispositif de contrôle.

Selon une variante :
- le premier dispositif de contrôle comporte un circuit d'auto maintien maintenant sélectivement un signal d'activation sur ladite interface de commande ;
- ladite interface de commande de l'interrupteur commande l'alimentation dudit premier dispositif de contrôle lors de l'application dudit signal logique sur la deuxième interface de sortie ou lors de l'application du signal d'activation sur cette interface de commande.

Selon encore une variante:
- le circuit de communication comprend un diviseur de tension connecté entre la deuxième interface de sortie et un potentiel d'alimentation du premier dispositif de contrôle;
- ladite interface de commande de l'interrupteur commandé est connectée à un noeud intermédiaire entre le diviseur de tension et ladite deuxième interface de sortie ;
- ladite première interface d'entrée est connectée à un noeud intermédiaire dudit diviseur de tension.

Selon une autre variante:
- ledit circuit de communication comporte une source de tension continue et un interrupteur commandé comportant une interface de commande, cet interrupteur commandé étant connectés en série avec ledit diviseur de tension entre ladite source de tension continue et ledit potentiel d'alimentation du premier dispositif de contrôle ;
- ladite deuxième interface de sortie étant connectée à l'interface de commande de l'interrupteur commandé du circuit de communication.

Selon encore une autre variante, ladite source de tension continue est formée d'un potentiel d'alimentation dudit deuxième dispositif de contrôle.

Selon une variante, ledit premier dispositif de contrôle inclut un circuit de traitement configuré pour commander sélectivement au circuit d'auto maintien la fin du maintien du signal d'activation sur ladite interface de commande dudit interrupteur commandé du premier circuit d'alimentation.

Selon encore une variante, ledit circuit de communication comprend un circuit comprenant une première résistance et un interrupteur commandé connectés en parallèle, ce dernier circuit étant connecté en série avec une deuxième résistance entre un potentiel d'alimentation du deuxième dispositif de contrôle et ladite première interface d'entrée, ledit noeud du circuit de communication étant un noeud intermédiaire entre les première et deuxième résistances, ladite deuxième interface de commande étant connectée à une interface de commande dudit interrupteur commandé du circuit de communication.

Selon une variante, ledit noeud du circuit de communication est connecté à ladite interface de commande de l'interrupteur commandé du premier circuit d'alimentation.

Selon une autre variante, ledit circuit de communication comprend une troisième résistance connectée en série avec la deuxième résistance, ladite troisième résistance étant connectée entre ladite première interface d'entrée et un potentiel d'alimentation dudit premier dispositif de contrôle.

Selon encore une autre variante, le système comprend en outre :
- un troisième étage d'accumulateurs connecté en série avec les premier et deuxième étages ;
- un troisième dispositif de contrôle alimenté par l'intermédiaire des potentiels aux bornes d'au moins un accumulateur du troisième étage, configuré pour mesurer la différence de potentiel aux bornes dudit troisième étage, comprenant une troisième interface de sortie et une troisième interface d'entrée, ledit deuxième dispositif de contrôle comprenant une deuxième interface d'entrée, le troisième dispositif de contrôle étant configuré pour appliquer, sur ladite troisième interface de sortie, une séquence numérique codant la différence de potentiel mesurée par le troisième dispositif de contrôle ;
- un autre circuit de communication par l'intermédiaire duquel la troisième interface de sortie communique avec ladite deuxième interface d'entrée ;
- un deuxième circuit d'alimentation incluant un interrupteur commandé appliquant ou coupant sélectivement l'alimentation dudit deuxième dispositif de contrôle, une interface de commande de cet interrupteur commandé étant connectée à un noeud de cet autre circuit de communication de sorte que le maintien d'au moins un niveau logique sur ladite troisième interface de sortie implique l'application de ladite alimentation sur ledit deuxième dispositif de contrôle.

Selon une variante, ledit circuit de commande est isolé galvaniquement par rapport auxdits accumulateurs électrochimiques et est configuré pour transmettre une commande de coupure à une interface d'entrée d'un dispositif de contrôle, ce dernier dispositif de contrôle étant alimenté par un étage de la batterie connecté à un des pôles de la batterie.

D'autres caractéristiques et avantages de l'invention ressortiront clairement de la description qui en est faite ci-après, à titre indicatif et nullement limitatif, en référence aux dessins annexés, dans lesquels :
- la figure 1 est une représentation schématique d'un premier mode de réalisation d'un système de batterie d'accumulateurs selon l'invention ;
- la figure 2 est un chronogramme illustrant différents signaux et l'état de certains interrupteurs du système de la figure 1 ;
- la figure 3 représente un exemple de mise en oeuvre du mode de réalisation de la figure 1 ;
- la figure 4 est une représentation schématique d'un deuxième mode de réalisation d'un système de batterie d'accumulateurs selon l'invention ;
- la figure 5 est un chronogramme illustrant différents signaux et l'état de certains interrupteurs du système de la figure 4 ;
- la figure 6 représente un exemple de mise en oeuvre du mode de réalisation de la figure 4.

L'invention propose d'utiliser un circuit de communication entre les dispositifs de contrôle de deux étages adjacents, afin qu'un de ces dispositifs de contrôle puisse commander l'application d'une alimentation à l'autre de ces dispositifs de contrôle.

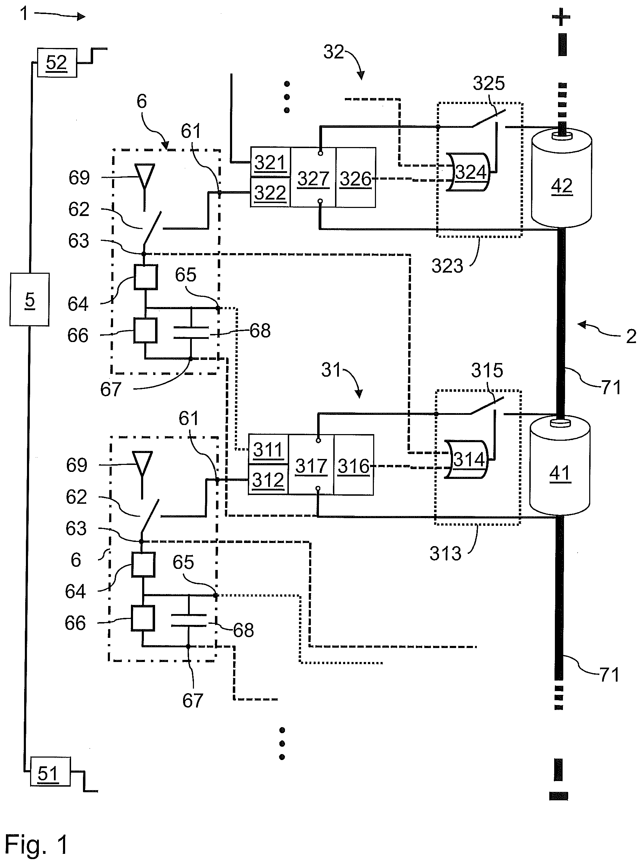

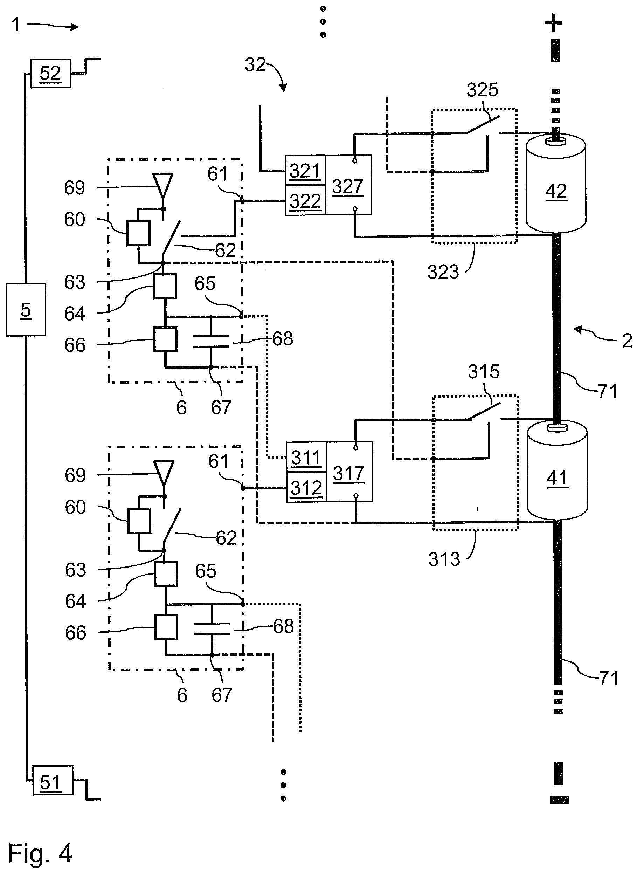

La figure 1 illustre schématiquement un système de batterie d'accumulateurs 1 selon un premier mode de réalisation de l'invention. La figure 4 illustre schématiquement un système de batterie d'accumulateurs 1 selon un deuxième mode de réalisation de l'invention.

Un système 1 selon ces modes de réalisation peut par exemple être mis en oeuvre pour assurer l'entraînement d'un moteur électrique. Le système 1 comprend une batterie 2 incluant des étages d'accumulateurs électrochimiques connectés en série. La batterie 2 comprend par exemple un grand nombre d'étages, incluant typiquement entre 20 et 100 accumulateurs connectés en série en fonction de la tension nécessaire et du type d'accumulateurs utilisé. Les étages sont connectés en série par l'intermédiaire de connexions électriques de puissance 71.

Chaque étage comporte un dispositif de contrôle qui lui est accolé. Les dispositifs de contrôle peuvent par exemple être mis en oeuvre sous la forme de microcontrôleurs. En particulier, un circuit de contrôle 31 est accolé à l'étage 41 et un circuit de contrôle 32 est accolé à l'étage 42. Chaque dispositif de contrôle comporte une interface d'entrée et une interface de sortie. Les dispositifs de contrôle sont configurés pour mesurer la différence de potentiel aux bornes de l'étage auquel ils sont accolés. Les dispositifs de contrôle sont également configurés pour communiquer de proche en proche, notamment des valeurs de différences de potentiels mesurées. Ainsi, deux dispositifs d'étages adjacents comportent une interface de sortie de l'un connectée à l'interface d'entrée de l'autre par l'intermédiaire d'un circuit de communication 6 dédié à ces étages adjacents.

Dans les modes de réalisation des figures 1 et 4, les dispositifs de contrôle 31 et 32 sont par exemple des dispositifs de contrôle esclaves, incluant des interfaces d'entrée respectives 311 et 321, et des interfaces de sortie respectives 312 et 322. Le dispositif de contrôle 5 est un dispositif de contrôle maître, connecté aux extrémités de la chaîne de communication formée par les différents dispositifs de contrôle. Le dispositif de contrôle 5 est connecté par l'intermédiaire d'un dispositif d'isolation galvanique 52 à l'interface d'entrée du dispositif de contrôle qui est connecté à la borne positive de la batterie. Le dispositif de contrôle 5 est connecté par l'intermédiaire d'un dispositif d'isolation galvanique 51 à l'interface de sortie du dispositif de contrôle qui est connecté à la borne négative de la batterie. L'unité centrale 5 récupère typiquement des valeurs de différence de potentiel mesurées par les dispositifs de contrôle, et fournit des commandes à ces dispositifs de contrôle.

On va maintenant davantage décrire le mode de réalisation de la figure 1. Un circuit d'alimentation 313 est configuré pour alimenter sélectivement le dispositif de contrôle 31, à partir de la différence de potentiel aux bornes de l'étage 41. Le circuit d'alimentation 313 peut être intégré dans le dispositif de contrôle 31 ou être formé d'un composant indépendant. Le circuit d'alimentation 313 comprend un interrupteur commandé 315 et une interface de commande 314 de cet interrupteur 315. L'interface de commande 314 est ici formée d'une porte OU dont la sortie est connectée à une électrode de commande de l'interrupteur 315. L'interrupteur commandé 315 est ici configuré pour ouvrir ou fermer la connexion entre le dispositif de contrôle 31 et le potentiel supérieur de l'étage 41. Le dispositif de contrôle 31 comporte un circuit de traitement 317 et un circuit d'auto-maintien 316. Le circuit d'auto-maintien 316 est ici connecté à l'entrée de l'interface de commande 314. Le circuit d'auto-maintien 316 est configuré pour générer un signal d'activation, de façon continue lorsque le dispositif de contrôle 31 est alimenté et est dans un mode de fonctionnement normal.

Un circuit d'alimentation 323 est configuré pour alimenter sélectivement le dispositif de contrôle 32, à partir de la différence de potentiel aux bornes de l'étage 42. Le circuit d'alimentation 323 peut être intégré dans le dispositif de contrôle 32 ou être formé d'un composant indépendant. Le circuit d'alimentation 323 comprend un interrupteur commandé 325 et une interface de commande 324 de cet interrupteur 325. L'interface de commande 324 est ici formée d'une porte OU dont la sortie est connectée à une électrode de commande de l'interrupteur 325. L'interrupteur commandé 325 est ici configuré pour ouvrir ou fermer la connexion entre le dispositif de contrôle 32 et le potentiel supérieur de l'étage 42. Le dispositif de contrôle 32 comporte un circuit de traitement 327 et un circuit d'auto-maintien 326. Le circuit d'auto-maintien 326 est ici connecté à l'entrée de l'interface de commande 324. Le circuit d'auto-maintien 326 est configuré pour générer un signal d'activation, de façon continue lorsque le dispositif de contrôle 32 est alimenté et est dans un mode de fonctionnement normal.

Pour chaque communication entre deux dispositifs de contrôle adjacents, le système 1 comporte un circuit de communication 6 dédié. Par la suite, on décrit le circuit de communication 6 destiné à mettre en communication la sortie 322 du dispositif de contrôle 32 avec l'interface d'entrée 311 du dispositif de contrôle 31. Ce circuit de communication 6 comporte une borne d'entrée 61 et une borne de sortie 65. La borne d'entrée 61 est connectée à l'interface de sortie 322 et la borne de sortie 65 est connectée à l'interface d'entrée 311. Le circuit de communication 6 comporte ici un interrupteur commandé 62 et un diviseur de tension connectés en série entre une source de tension continue 69 et une borne 67 à un potentiel de référence. La borne 67 est ici connectée au potentiel inférieur de l'étage 41. Le diviseur de tension comporte ici une résistance 64 et une résistance 66 connectées en série. Un condensateur 68 est connecté en parallèle de la résistance 66 entre la borne de sortie 65 et la borne 67. La combinaison du condensateur 68 et de la résistance 66 forme avantageusement un filtre RC limitant la bande passante aux fréquences utilisées pour la communication entre les dispositifs de contrôle 32 et 31.

Le circuit de communication 6 comporte un noeud intermédiaire 63 entre l'interrupteur commandé 62 et le diviseur de tension. Ce noeud intermédiaire 63 est connecté à une entrée de l'interface de commande 314.

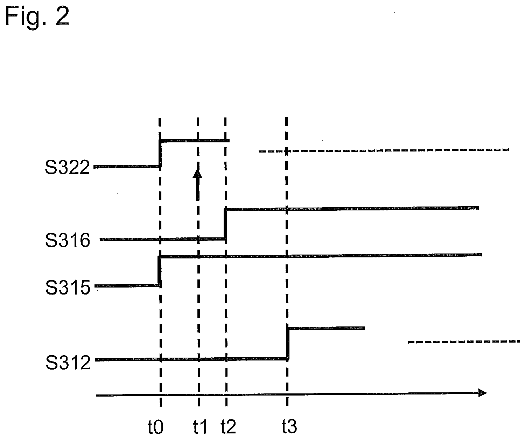

Le fonctionnement du système 1 va maintenant être détaillé en référence au chronogramme de la figure 2, illustrant des niveaux logiques au niveau de différents éléments. On va détailler un exemple d'allumage en chaîne de dispositifs de contrôle esclaves. Au préalable, le dispositif de contrôle maître 5 commande l'alimentation du dispositif de contrôle esclave associé à l'étage connecté à la borne positive de la batterie. Les dispositifs de contrôle esclaves sont alimentés de façon chaînée, jusqu'à ce que le dispositif de contrôle 32 soit alimenté et que son circuit de traitement 327 et son circuit d'auto maintien 326 soient opérationnels. A l'instant t0, le circuit de traitement 327 commande le maintien d'un niveau logique sur l'interface de sortie 322, ici le niveau logique 1 ou état haut d'un codage binaire. Le niveau logique 1 appliqué sur la borne d'entrée 61 par l'interface de sortie 322 maintient l'interrupteur 62 fermé. Le potentiel de la source de tension 69 est alors appliqué sur le noeud intermédiaire 63.

Le maintien du niveau logique 1 sur l'interface de sortie 322 implique ainsi le maintien du potentiel de la source de tension 69 sur une entrée de la porte OU 314. Ce potentiel appliqué forme un niveau logique 1 sur la porte OU 314. La sortie de la porte OU 314 est alors au niveau logique 1 et commande la fermeture de l'interrupteur 315. Le dispositif de contrôle 31 est alors alimenté par l'étage 41. À l'instant t1, le circuit de traitement 317 est démarré et fonctionnel. Le circuit de traitement 317 commande le démarrage du circuit d'auto maintien 316. À l'instant t2, le circuit d'auto maintien 316 est démarré et opérationnel. Le niveau logique 1 est ici maintenu par l'interface de sortie 322 pendant une durée suffisante pour garantir la génération du signal d'activation par le circuit d'auto maintien 316. Dès lors, le circuit d'auto maintien 316 maintient en continu un signal d'activation, ici un niveau logique 1, sur une entrée de la porte OU 314. Le circuit d'auto maintien 316 garantit alors un niveau logique 1 sur la sortie de la porte OU 314 et la fermeture de l'interrupteur 315. Une variation du niveau logique sur l'interface de sortie 322 est alors possible sans couper l'alimentation du dispositif de contrôle 31.

Une communication entre le dispositif de contrôle 32 et le dispositif de contrôle 31 peut alors être réalisée par l'intermédiaire du circuit de communication 6, sans altérer l'alimentation du dispositif de contrôle 31. Une telle communication est illustrée par un trait discontinu, le niveau logique de la communication étant variable. La communication sera typiquement utilisée pour transmettre une séquence numérique codant la différence de potentiel mesurée aux bornes de l'étage 42 par le circuit de traitement 327. Une communication initiale du dispositif de contrôle 32 vers le dispositif de contrôle 31 peut aussi inclure une confirmation d'une requête d'alimentation ou la transmission d'une commande d'alimentation du dispositif de contrôle esclave suivant dans la chaîne.

A l'instant t3, le circuit de traitement 317 commande le maintien d'un niveau logique 1 sur l'interface de sortie 312 afin de procéder à l'alimentation d'un autre dispositif de contrôle auquel il est connecté par un circuit de communication 6. Une alimentation chaînée des dispositifs de contrôle est alors obtenue. Lorsque l'ensemble des dispositifs de contrôle esclaves sont alimentés, une communication chaînée des mesures de différence de potentiel peut être transmise au circuit de contrôle maître 5.

Dans le cas présent, un niveau logique 0 sur l'interface de sortie 322 ouvre l'interrupteur 62, provoquant l'abaissement du potentiel sur le noeud intermédiaire 63 jusqu'à un niveau logique zéro pour une entrée de la porte OU 314.

En dehors des périodes de mesure de différences de potentiel, l'alimentation des différents dispositifs de contrôle esclaves peut être coupée, de sorte que ces dispositifs de contrôle esclaves n'induisent pas de consommation de courant sur leurs étages respectifs. L'autonomie du système 1 après une charge est ainsi très fortement accrue, en particulier pour des phases de stockage prolongées. Par ailleurs, la commande de fermeture des interrupteurs commandés des circuits d'alimentation, en vue d'alimenter les différents dispositifs de contrôle esclaves, est avantageusement réalisée avec des circuits de communication 6 préexistants, sans nécessiter un câblage de commande spécifique entre le dispositif de contrôle maître 5 et ces interrupteurs. Le dispositif de contrôle maître 5 peut être maintenu alimenté en continu soi par la batterie, soit par une batterie annexe.

Pour couper l'alimentation des différents dispositifs de contrôle esclaves, le dispositif de contrôle maître 5 peut transmettre un ordre d'extinction à un premier dispositif de contrôle esclave. L'ordre d'extinction peut être transmis de façon chaînée entre les dispositifs de contrôle esclaves par l'intermédiaire de circuits de communication 6. Le circuit de traitement de chaque dispositif de contrôle esclave traite un ordre d'extinction en commandant au circuit d'auto maintien d'interrompre la génération du signal d'activation. Ainsi, au moins un niveau logique sur la porte OU de son circuit d'alimentation est à 0. Si l'autre entrée de cette porte OU reçoit un niveau logique 0 du circuit de communication 6 auquel elle est connectée, cette porte OU fournit un niveau logique zéro en sortie. Des lors, l'interrupteur commandé du circuit d'alimentation de ce dispositif de contrôle s'ouvre.

La source de tension 69 de chaque circuit de communication 6 peut être à un niveau adapté au potentiel d'alimentation des dispositifs de contrôle esclaves auquel ce circuit de communication 6 est connecté. Par exemple, un potentiel d'alimentation du dispositif de contrôle 32 peut être appliqué comme potentiel de la source de tension 69 du circuit de communication 6 mettant en communication le dispositif de contrôle 32 avec le dispositif de contrôle 31. Ce potentiel est par exemple le potentiel supérieur de l'étage 42, appliqué au dispositif de contrôle 32 par l'interrupteur 325 fermé.

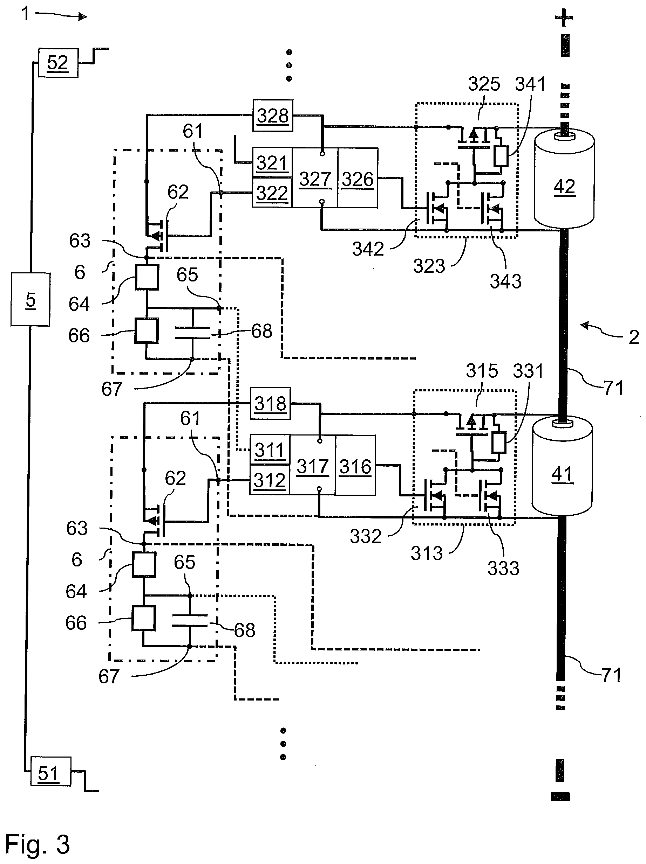

Dans l'exemple de mise en oeuvre illustré à la figure 3, le potentiel inférieur d'alimentation du dispositif de contrôle 31 est appliqué sur la borne 67 du circuit de communication 6 permettant la communication avec le dispositif de contrôle 32. Le potentiel supérieur d'alimentation du dispositif de contrôle 32 est utilisé comme source de tension de ce circuit de communication 6. Avec un diviseur de tension de dimensionnement approprié, on peut garantir que le potentiel appliqué sur l'interface d'entrée 311 est systématiquement compris entre les potentiels d'alimentation du dispositif de contrôle 31, quel que soit le niveau logique du signal appliqué par l'interface de sortie 322. On peut par exemple envisager que la résistance 64 et la résistance 66 présentent de mêmes valeurs de résistance. D'autres valeurs de résistance peuvent bien entendu être utilisées, en utilisant par exemple une résistance 64 ayant une valeur de résistance double de celle de la résistance 66.

Dans cet exemple de mise en oeuvre, les dispositifs de contrôle 31 et 32 comportent avantageusement des régulateurs de tension respectifs 318 et 328, permettant d'appliquer des niveaux de potentiel régulés comme sources de tension des circuits de communication 6. Les régulateurs de tension 318 et 328 peuvent également alimenter respectivement les dispositifs de contrôle 31 et 32. Ces régulateurs 318 et 328 sont alimentés par le potentiel supérieur respectif de leur dispositif de contrôle.

Dans l'exemple de mise en oeuvre de la figure 3, l'interrupteur commandé 315 du circuit d'alimentation 313 est réalisé sous la forme d'un transistor pMOS muni d'une résistance 331 entre source et grille. La source du transistor 315 est connectée au potentiel supérieur de l'étage 41. L'interface de commande du transistor 315 est formée par l'intermédiaire de transistors NMOS 332 et 333. La source des transistors 332 et 333 est connectée au potentiel inférieur de l'étage 41. Le drain des transistors 332 et 333 est connecté à la grille du transistor 315. La grille du transistor 332 est commandée par le signal d'activation du circuit de maintien 316. La grille du transistor 333 est commandée par le potentiel du noeud 63 du circuit de communication 6 entre les dispositifs de contrôle 31 et 32. Ainsi, si le transistor 332 ou le transistor 333 est rendu passant par le signal appliqué sur sa grille, le transistor 315 est également rendu passant.

Le circuit d'alimentation 323 présente une structure similaire au circuit d'alimentation 313. L'interrupteur commandé 325 est réalisé sous la forme d'un transistor pMOS muni d'une résistance 341 entre source et grille. La source du transistor 325 est connectée au potentiel supérieur de l'étage 42. L'interface de commande du transistor 325 est formée par l'intermédiaire de transistors nMOS 342 et 343. La source des transistors 342 et 343 est connectée au potentiel inférieur de l'étage 42. Le drain des transistors 342 et 343 est connecté à la grille du transistor 325. La grille du transistor 342 est commandée par le signal d'activation du circuit de maintien 326. La grille du transistor 343 est commandée par le potentiel du noeud 63 d'un circuit de communication 6.

Dans les circuits de communication 6, l'interrupteur commandé 62 est mis en oeuvre sous la forme d'un transistor pMOS. Le drain du transistor 62 est connecté au noeud intermédiaire 63. La source du transistor 62 est connectée au potentiel de la source de tension du circuit de communication 6. La grille du transistor 62 est connectée à l'interface de sortie d'un des dispositifs de contrôle auquel le circuit de communication 6 est connecté.

Le mode de réalisation de la figure 4 est destiné à favoriser une alimentation plus rapide de l'ensemble des dispositifs de contrôle esclaves. En outre, ce deuxième mode de réalisation permet de communiquer en appliquant des changements d'état sur les circuits de communication, sans pour autant altérer le processus d'alimentation et de démarrage des dispositifs de contrôle.

Un circuit d'alimentation 313 est configuré pour alimenter sélectivement le dispositif de contrôle 31, à partir de la différence de potentiel aux bornes de l'étage 41. Le circuit d'alimentation 313 comprend un interrupteur commandé 315. L'interrupteur commandé 315 est ici configuré pour ouvrir ou fermer la connexion entre le dispositif de contrôle 31 et le potentiel supérieur de l'étage 41. L'interface de commande de l'interrupteur 315 est ici formée d'une borne de commande du circuit d'alimentation 313. Le niveau du signal appliqué sur la borne de commande de ce circuit d'alimentation 313 permet sélectivement de fermer ou ouvrir l'interrupteur 315. Le dispositif de contrôle 31 comporte un circuit de traitement 317.

Un circuit d'alimentation 323 est configuré pour alimenter sélectivement le dispositif de contrôle 32, à partir de la différence de potentiel aux bornes de l'étage 42. Le circuit d'alimentation 323 comprend un interrupteur commandé 325. L'interrupteur commandé 325 est ici configuré pour ouvrir ou fermer la connexion entre le dispositif de contrôle 32 et le potentiel supérieur de l'étage 42. L'interface de commande de l'interrupteur 325 est ici formée d'une borne de commande du circuit d'alimentation 323. Le niveau du signal appliqué sur la borne de commande de ce circuit d'alimentation 323 permet sélectivement de fermer ou ouvrir l'interrupteur 325. Le dispositif de contrôle 32 comporte un circuit de traitement 327.

Pour chaque communication entre deux dispositifs de contrôle adjacents, le système 1 comporte un circuit de communication 6 dédié. Par la suite, on décrit le circuit de communication 6 destiné à mettre en communication la sortie 322 du dispositif de contrôle 32 avec l'interface d'entrée 311 du dispositif de contrôle 31. Ce circuit de communication 6 comporte une borne d'entrée 61 et une borne de sortie 65. La borne d'entrée 61 est connectée à l'interface de sortie 322 et la borne de sortie 65 est connectée à l'interface d'entrée 311. Le circuit de communication 6 comporte ici un interrupteur commandé 62 et une résistance 60 connectés en parallèle. La résistance 60 forme ainsi une dérivation de l'interrupteur 62. L'association de l'interrupteur 62 et de la résistance 60 est connectée en série avec un diviseur de tension entre une source de tension continue 69 et une borne 67 à un potentiel de référence. La borne 67 est ici connectée au potentiel inférieur de l'étage 41. Le diviseur de tension comporte ici une résistance 64 et une résistance 66 connectées en série. Un condensateur 68 est connecté en parallèle de la résistance 66 entre la borne de sortie 65 et la borne 67. La source de tension continue 69 est ici formée par le potentiel appliqué par l'interrupteur 325 lorsqu'il est fermé. Le circuit de communication 6 comporte un noeud intermédiaire 63 entre l'interrupteur commandé 62 et le diviseur de tension. Ce noeud intermédiaire 63 est connecté à la borne de commande du circuit d'alimentation 313 formant l'interface de commande de l'interrupteur 315.

La combinaison des résistances 60, 64 et 66 et de l'interrupteur 62 forment un diviseur de tension entre la borne 67 et la source de tension 69, avec une valeur de résistance variable, en fonction de l'ouverture ou de la fermeture de l'interrupteur 62. Lorsque l'interrupteur 62 est fermé, la résistance 60 est court-circuitée et la valeur de résistance entre la borne 67 et la source de tension 69 est alors égale à la somme des valeurs de résistance des résistances 64 et 66. Lorsque l'interrupteur 62 est ouvert, la valeur de résistance entre la borne 67 et la source de tension 69 est alors égale à la somme des valeurs de résistance des résistances 60, 64 et 66. Ainsi, dès que la source de tension 69 applique un potentiel d'alimentation, quel que soit le niveau logique appliqué par l'interface de sortie 322 sur la commande de l'interrupteur 62, un potentiel suffisant est appliqué sur le noeud intermédiaire 63 pour provoquer le maintien de l'interrupteur 315 fermé.

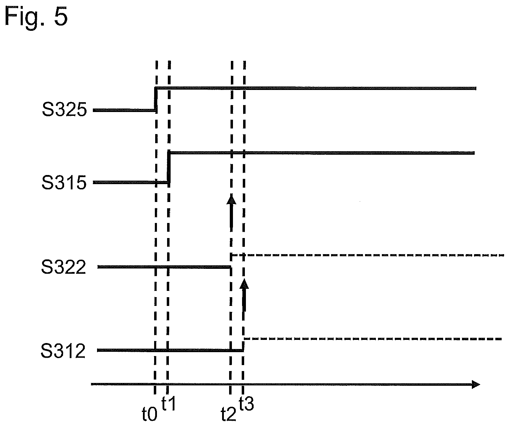

Le fonctionnement du système 1 va maintenant être détaillé en référence au chronogramme de la figure 5, illustrant des niveaux logiques au niveau de différents éléments. On va détailler un exemple d'allumage en chaîne de dispositifs de contrôle esclaves. Au préalable, le dispositif de contrôle maître 5 commande l'alimentation du dispositif de contrôle esclave associé à l'étage connecté à la borne positive de la batterie, en commandant la fermeture de l'interrupteur commandé de son circuit d'alimentation.

Les dispositifs de contrôle esclaves sont alimentés de façon chaînée, jusqu'à ce que l'interrupteur commandé 325 soit fermé et que le dispositif de contrôle 32 soit alimenté. Dès l'instant t0, l'interrupteur 325 est fermé. Dès l'instant t0 (avec un léger décalage par rapport à t0 si la source de tension 69 est régulée), la source de tension 69 applique un potentiel sur le noeud 63 par l'intermédiaire de la résistance 60. Dès l'instant t1, l'interrupteur 315 est fermé. À un instant t2, le circuit de traitement 327 est démarré et opérationnel. Le dispositif de contrôle 32 peut alors communiquer avec le dispositif de contrôle 31 par l'intermédiaire de leur circuit de communication 6. A un instant t3, le circuit de traitement 317 est démarré et opérationnel.

Le décalage entre l'alimentation des différents dispositifs de contrôle esclaves est donc relativement limité, l'alimentation étant ici indépendante du démarrage et du fonctionnement effectif du circuit de traitement de chacun de ces dispositifs de contrôle esclaves. L'alimentation du dispositif de contrôle 31 est par exemple indépendante des commutations de l'interrupteur 62, commandées par le niveau du signal appliqué sur l'interface de sortie 322.

Pour couper l'alimentation des différents dispositifs de contrôle esclaves, le dispositif de contrôle maître 5 peut transmettre un ordre d'extinction à un premier circuit d'alimentation d'un dispositif de contrôle esclave. L'ordre d'extinction est alors automatiquement transmis de façon chaînée entre les dispositifs de contrôle esclaves par l'intermédiaire de circuits de communication 6, au fur et à mesure que les potentiels sur les noeuds 63 ne sont plus alimentés par une source de tension.

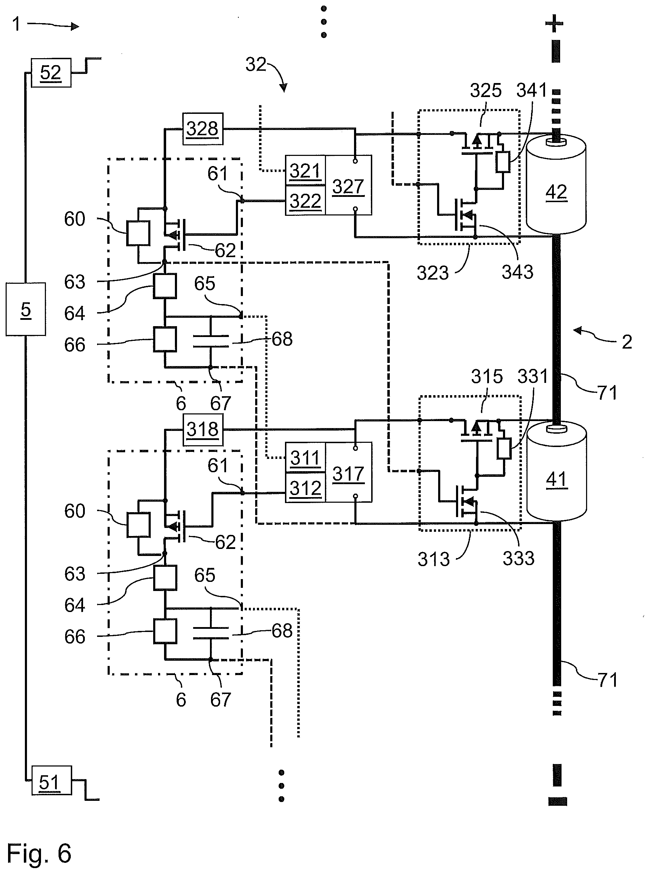

Dans l'exemple de mise en oeuvre illustré à la figure 6, le potentiel inférieur d'alimentation du dispositif de contrôle 31 est appliqué sur la borne 67 du circuit de communication 6 le mettant en communication avec le dispositif de contrôle 32. Le potentiel supérieur d'alimentation du dispositif de contrôle 32 est utilisé comme source de tension de ce circuit de communication 6. Avec un diviseur de tension de dimensionnement approprié entre la borne 67 et la source de tension, on peut garantir que le potentiel appliqué sur l'interface d'entrée 311 est systématiquement compris entre les potentiels d'alimentation du dispositif de contrôle 31, quel que soit le niveau logique du signal appliqué par l'interface de sortie 322.

Dans cet exemple de mise en oeuvre, les dispositifs de contrôle 31 et 32 comportent avantageusement des régulateurs de tension respectifs 318 et 328, permettant d'appliquer des niveaux de potentiel régulés comme sources de tension des circuits de communication 6. Ces régulateurs sont alimentés par le potentiel supérieur respectif de leur dispositif de contrôle.

Dans l'exemple de mise en oeuvre de la figure 6, l'interrupteur commandé 315 du circuit d'alimentation 313 est réalisé sous la forme d'un transistor pMOS muni d'une résistance 331 entre source et grille. La source du transistor 315 est connectée au potentiel supérieur de l'étage 41. L'interface de commande du transistor 315 est formée par l'intermédiaire d'un transistor NMOS 333. La source du transistor 333 est connectée au potentiel inférieur de l'étage 41. Le drain du transistor 333 est connecté à la grille du transistor 315. La grille du transistor 333 est commandée par le potentiel du noeud 63 du circuit de communication 6 entre les dispositifs de contrôle 31 et 32. Ainsi, un potentiel est appliqué sur le noeud 63 par la source de tension, le transistor 315 étant alors rendu passant.

Le circuit d'alimentation 323 présente une structure similaire au circuit d'alimentation 313. L'interrupteur commandé 325 est réalisé sous la forme d'un transistor pMOS muni d'une résistance 341 entre source et grille. La source du transistor 325 est connectée au potentiel supérieur de l'étage 42. L'interface de commande du transistor 325 est formée par l'intermédiaire d'un transistor NMOS 343. La source du transistor 343 est connectée au potentiel inférieur de l'étage 42. Le drain du transistor 343 est connecté à la grille du transistor 325. La grille du transistor 343 est commandée par le potentiel du noeud 63 d'un circuit de communication 6.

Dans les circuits de communication 6, l'interrupteur commandé 62 est mis en oeuvre sous la forme d'un transistor pMOS. Le drain du transistor 62 est connecté au noeud intermédiaire 63. La source du transistor 62 est connectée au potentiel de la source de tension du circuit de communication 6. La grille du transistor 62 est connectée à l'interface de sortie d'un des dispositifs de contrôle auquel le circuit de communication 6 est connecté.

Chaque dispositif de contrôle peut mettre en oeuvre des commandes reçues d'une unité centrale ou d'un dispositif de contrôle maître, par exemple pour appliquer un courant de décharge aux bornes de son étage. Un tel courant de décharge peut par exemple être mis en oeuvre pour procéder à un équilibrage de charge des étages.

Dans les modes de réalisation illustrés précédemment, la communication s'effectue de façon descendante du dispositif de contrôle connecté à un étage de plus haut potentiel vers un dispositif de contrôle connecté à un étage de plus bas potentiel. L'invention s'applique bien entendu également à un système dans lequel la communication s'effectue de façon ascendante, d'un dispositif de contrôle connecté à un étage de plus bas potentiel vers un dispositif de contrôle connecté à un étage de plus haut potentiel.

Les dispositifs de contrôle utilisés peuvent également mettre en oeuvre à la fois une communication ascendante entre dispositifs de contrôle, et une communication descendante entre dispositifs de contrôle. A cet effet, chaque dispositif de contrôle peut comporter deux interfaces d'entrée (une première destinée à communiquer avec une interface de sortie du dispositif de contrôle de l'étage, une deuxième destinée à communiquer avec une interface de sortie du dispositif de contrôle de l'étage inférieur) et deux interfaces de sortie (une première destinée à communiquer avec une interface d'entrée du dispositif de contrôle de l'étage supérieur, une deuxième destinée à communiquer avec une interface d'entrée du dispositif de contrôle de l'étage inférieur).

Dans les modes de réalisation illustrés précédemment, le niveau logique de commande d'ouverture est défini par un niveau de potentiel. On peut également envisager que ce niveau logique soit défini par un état haute impédance sur une interface de sortie d'un dispositif de contrôle esclave.

Dans les modes de réalisation illustrés précédemment les interfaces de sortie des dispositifs esclaves sont configurées pour appliquer des séquences numériques binaires sur les circuits de communication. On peut également envisager des séquences numériques codées par un plus grand nombre de niveaux logiques, au moins un de ces niveaux logiques impliquant la fermeture d'un interrupteur commandé d'alimentation d'un dispositif de contrôle esclave adjacent.

## Revendications

1. Système (1) de batterie d'accumulateurs, comprenant :
- des premier et deuxième étages d'accumulateurs électrochimiques (41, 42) connectés en série ;
- un premier dispositif de contrôle (31) alimenté par l'intermédiaire des potentiels aux bornes d'au moins un accumulateur du premier étage (41), configuré pour mesurer la différence de potentiel aux bornes dudit premier étage, comprenant une première interface de sortie (312) et une première interface d'entrée (311) ;
- un deuxième dispositif de contrôle (32) alimenté par l'intermédiaire des potentiels aux bornes d'au moins un accumulateur du deuxième étage (42), configuré pour mesurer la différence de potentiel aux bornes dudit deuxième étage, comprenant une deuxième interface de sortie (322), le deuxième dispositif de contrôle (32) étant configuré pour appliquer, sur ladite deuxième interface de sortie, une séquence numérique codant la différence de potentiel mesurée par le deuxième dispositif de contrôle ;
- un circuit de communication (6) configuré pour que la deuxième interface de sortie (322) communique par son intermédiaire avec ladite première interface d'entrée (311) ;
**caractérisé en ce qu'**il comprend en outre :
- un premier circuit d'alimentation (313) incluant un interrupteur commandé (315) configuré pour appliquer ou pour couper sélectivement l'alimentation dudit premier dispositif de contrôle (31), une interface de commande (314) de l'interrupteur (315) étant connectée à un noeud (63) du circuit de communication (6) de sorte que le maintien d'au moins un niveau logique sur ladite deuxième interface de sortie (322) implique l'application de ladite alimentation sur ledit premier dispositif de contrôle (31) ;
- au moins un circuit de commande (317) configuré pour commander sélectivement la coupure de l'alimentation dudit premier dispositif de contrôle (31).

2. Système selon la revendication 1, dans lequel :
- le premier dispositif de contrôle (31) comporte un circuit d'auto maintien (316) maintenant sélectivement un signal d'activation sur ladite interface de commande (314) ;
- ladite interface de commande (314) de l'interrupteur commande l'alimentation dudit premier dispositif de contrôle (31) lors de l'application dudit signal logique sur la deuxième interface de sortie (322) ou lors de l'application du signal d'activation sur cette interface de commande.

3. Système selon la revendication 2, dans lequel :
- le circuit de communication (6) comprend un diviseur de tension (64,66) connecté entre la deuxième interface de sortie (322) et un potentiel d'alimentation du premier dispositif de contrôle;
- ladite interface de commande (314) de l'interrupteur commandé (315) est connectée à un noeud intermédiaire entre le diviseur de tension et ladite deuxième interface de sortie ;
- ladite première interface d'entrée (311) est connectée à un noeud intermédiaire dudit diviseur de tension (64,66).

4. Système selon la revendication 3, dans lequel :
- ledit circuit de communication (6) comporte une source (69) de tension continue et un interrupteur commandé (62) comportant une interface de commande, cet interrupteur commandé étant connectés en série avec ledit diviseur de tension entre ladite source de tension continue (69) et ledit potentiel d'alimentation du premier dispositif de contrôle (31) ;
- ladite deuxième interface de sortie (322) étant connectée à l'interface de commande de l'interrupteur commandé (62) du circuit de communication.

5. Système selon la revendication 4, dans lequel ladite source de tension continue est formée d'un potentiel d'alimentation dudit deuxième dispositif de contrôle (32).

6. Système selon l'une quelconque des revendications 2 à 5, dans lequel ledit premier dispositif de contrôle inclut un circuit de traitement (317) configuré pour commander sélectivement au circuit d'auto maintien (316) la fin du maintien du signal d'activation sur ladite interface de commande (314) dudit interrupteur commandé du premier circuit d'alimentation.

7. Système selon la revendication 1, dans lequel ledit circuit de communication (6) comprend un circuit comprenant une première résistance (60) et un interrupteur commandé (62) connectés en parallèle, ce dernier circuit étant connecté en série avec une deuxième résistance entre un potentiel d'alimentation du deuxième dispositif de contrôle et ladite première interface d'entrée, ledit noeud (63) du circuit de communication étant un noeud intermédiaire entre les première et deuxième résistances, ladite deuxième interface de commande étant connectée à une interface de commande dudit interrupteur commandé du circuit de communication.

8. Système selon la revendication 7, dans lequel ledit noeud du circuit de communication est connecté à ladite interface de commande de l'interrupteur commandé du premier circuit d'alimentation.

9. Système selon la revendication 7 ou 8, dans lequel ledit circuit de communication comprend une troisième résistance connectée en série avec la deuxième résistance, ladite troisième résistance étant connectée entre ladite première interface d'entrée et un potentiel d'alimentation dudit premier dispositif de contrôle.

10. Système selon l'une quelconque des revendications précédentes, comprenant en outre :
- un troisième étage d'accumulateurs connecté en série avec les premier et deuxième étages ;
- un troisième dispositif de contrôle alimenté par l'intermédiaire des potentiels aux bornes d'au moins un accumulateur du troisième étage, configuré pour mesurer la différence de potentiel aux bornes dudit troisième étage, comprenant une troisième interface de sortie et une troisième interface d'entrée, ledit deuxième dispositif de contrôle comprenant une deuxième interface d'entrée, le troisième dispositif de contrôle étant configuré pour appliquer, sur ladite troisième interface de sortie, une séquence numérique codant la différence de potentiel mesurée par le troisième dispositif de contrôle ;
- un autre circuit de communication par l'intermédiaire duquel la troisième interface de sortie communique avec ladite deuxième interface d'entrée ;
- un deuxième circuit d'alimentation (323) incluant un interrupteur commandé (325) appliquant ou coupant sélectivement l'alimentation dudit deuxième dispositif de contrôle (32), une interface de commande (324) de cet interrupteur commandé (325)étant connectée à un noeud de cet autre circuit de communication de sorte que le maintien d'au moins un niveau logique sur ladite troisième interface de sortie implique l'application de ladite alimentation sur ledit deuxième dispositif de contrôle (32).

11. Système selon l'une quelconque des revendications précédentes, dans lequel ledit circuit de commande est isolé galvaniquement par rapport auxdits accumulateurs électrochimiques et est configuré pour transmettre une commande de coupure à une interface d'entrée d'un dispositif de contrôle, ce dernier dispositif de contrôle étant alimenté par un étage de la batterie connecté à un des pôles de la batterie.

## Patentansprüche

1. Akkumulatorenbatteriesystem (1), das enthält:
- erste und zweite Stufen von in Reihe geschalteten elektrochemischen Akkumulatoren (41, 42);
- eine erste Kontrollvorrichtung (31), die durch die Potentiale an den Klemmen mindestens eines Akkumulators der ersten Stufe (41) versorgt wird, konfiguriert, die Potentialdifferenz an den Klemmen der ersten Stufe zu messen, die eine erste Ausgangsschnittstelle (312) und eine erste Eingangsschnittstelle (311) enthält;
- eine zweite Kontrollvorrichtung (32), die durch die Potentiale an den Klemmen mindestens eines Akkumulators der zweiten Stufe (42) versorgt wird, konfiguriert, die Potentialdifferenz an den Klemmen der zweiten Stufe zu messen, die eine zweite Ausgangsschnittstelle (322) enthält, wobei die zweite Kontrollvorrichtung (32) konfiguriert ist, an die zweite Ausgangsschnittstelle eine digitale Sequenz anzuwenden, die die von der zweiten Kontrollvorrichtung gemessene Potentialdifferenz codiert;
- einen Verbindungsschaltkreis (6), der konfiguriert ist, damit die zweite Ausgangsschnittstelle (322) durch ihn mit der ersten Eingangsschnittstelle (311) in Verbindung steht;
**dadurch gekennzeichnet, dass** es außerdem enthält:
- einen ersten Versorgungsschaltkreis (313), der einen gesteuerten Schalter (315) enthält, der konfiguriert ist, selektiv die Versorgung der ersten Kontrollvorrichtung (31) anzuwenden oder zu unterbrechen, wobei eine Steuerschnittstelle (314) des Schalters (315) an einen Knoten (63) des Verbindungsschaltkreises (6) angeschlossen ist, damit die Aufrechterhaltung mindestens eines Logikpegels an der zweiten Ausgangsschnittstelle (322) das Anwenden der Versorgung an die erste Kontrollvorrichtung (31) impliziert;
- mindestens einen Steuerschaltkreis (317), der konfiguriert ist, das Unterbrechen der Versorgung der ersten Kontrollvorrichtung (31) selektiv zu steuern.

2. System nach Anspruch 1, wobei:
- die erste Kontrollvorrichtung (31) einen Selbsthaltungsschaltkreis (316) aufweist, der ein Aktivierungssignal selektiv an der Steuerschnittstelle (314) hält;
- die Steuerschnittstelle (314) des Schalters die Versorgung der ersten Kontrollvorrichtung (31) beim Anwenden des Logiksignals an die zweite Ausgangsschnittstelle (322) oder beim Anwenden des Aktivierungssignals an diese Steuerschnittstelle steuert.

3. System nach Anspruch 2, wobei:
- der Verbindungsschaltkreis (6) einen Spannungsteiler (64, 66) enthält, der zwischen der zweiten Ausgangsschnittstelle (322) und einem Versorgungspotential der ersten Kontrollvorrichtung angeschlossen ist;
- die Steuerschnittstelle (314) des gesteuerten Schalters (315) an einen Zwischenknoten zwischen dem Spannungsteiler und der zweiten Ausgangsschnittstelle angeschlossen ist;
- die erste Eingangsschnittstelle (311) an einen Zwischenknoten des Spannungsteilers (64, 66) angeschlossen ist.

4. System nach Anspruch 3, wobei:
- der Verbindungsschaltkreis (6) eine Gleichspannungsquelle (69) und einen gesteuerten Schalter (62) aufweist, der eine Steuerschnittstelle aufweist, wobei dieser gesteuerte Schalter zwischen der Gleichspannungsquelle (69) und dem Versorgungspotential der ersten Kontrollvorrichtung (31) mit dem Spannungsteiler in Reihe geschaltet ist;
- die zweite Ausgangsschnittstelle (322) an die Steuerschnittstelle des gesteuerten Schalters (62) des Verbindungsschaltkreises angeschlossen ist.

5. System nach Anspruch 4, wobei die Gleichspannungsquelle von einem Versorgungspotential der zweiten Kontrollvorrichtung (32) gebildet wird.

6. System nach einem der Ansprüche 2 bis 5, wobei die erste Kontrollvorrichtung einen Verarbeitungsschaltkreis (317) umfasst, der konfiguriert ist, dem Selbsthaltungsschaltkreis (316) das Ende des Haltens des Aktivierungssignals an der Steuerschnittstelle (314) des gesteuerten Schalters des ersten Versorgungsschaltkreises selektiv zu befehlen.

7. System nach Anspruch 1, wobei der Verbindungsschaltkreis (6) einen Schaltkreis enthält, der einen ersten Widerstand (60) und einen gesteuerten Schalter (62) parallelgeschaltet enthält, wobei letzterer Schaltkreis mit einem zweiten Widerstand zwischen einem Versorgungspotential der zweiten Kontrollvorrichtung und der ersten Eingangsschnittstelle in Reihe geschaltet ist, wobei der Knoten (63) des Verbindungsschaltkreises ein Zwischenknoten zwischen dem ersten und dem zweiten Widerstand ist, wobei die zweite Steuerschnittstelle an eine Steuerschnittstelle des gesteuerten Schalters des Verbindungsschaltkreises angeschlossen ist.

8. System nach Anspruch 7, wobei der Knoten des Verbindungsschaltkreises an die Steuerschnittstelle des gesteuerten Schalters des ersten Versorgungsschaltkreises angeschlossen ist.

9. System nach Anspruch 7 oder 8, wobei der Verbindungsschaltkreis einen dritten Widerstand enthält, der mit dem zweiten Widerstand in Reihe geschaltet ist, wobei der dritte Widerstand zwischen der ersten Eingangsschnittstelle und einem Versorgungspotential der ersten Kontrollvorrichtung angeschlossen ist.

10. System nach einem der vorhergehenden Ansprüche, das außerdem enthält:
- eine dritte Akkumulatorenstufe, die mit der ersten und der zweiten Stufe in Reihe geschaltet ist;
- eine dritte Kontrollvorrichtung, die durch die Potentiale an den Klemmen mindestens eines Akkumulators der dritten Stufe versorgt wird, konfiguriert, die Potentialdifferenz an den Klemmen der dritten Stufe zu messen, die eine dritte Ausgangsschnittstelle und eine dritte Eingangsschnittstelle enthält, wobei die zweite Kontrollvorrichtung eine zweite Eingangsschnittstelle enthält, wobei die dritte Kontrollvorrichtung konfiguriert ist, an die dritte Ausgangsschnittstelle eine digitale Sequenz anzuwenden, die die von der dritten Kontrollvorrichtung gemessene Potentialdifferenz codiert;
- einen weiteren Verbindungsschaltkreis, durch den die dritte Ausgangsschnittstelle mit der zweiten Eingangsschnittstelle in Verbindung steht;
- einen zweiten Versorgungsschaltkreis (323), der einen gesteuerten Schalter (325) umfasst, der die Versorgung der zweiten Kontrollvorrichtung (32) selektiv anwendet oder unterbricht, wobei eine Steuerschnittstelle (324) dieses gesteuerten Schalters (325) an einen Knoten dieses weiteren Verbindungsschaltkreises angeschlossen ist, damit der Halt mindestens eines Logikpegels an der dritten Ausgangsschnittstelle das Anwenden der Versorgung an die zweite Kontrollvorrichtung (32) impliziert.

11. System nach einem der vorhergehenden Ansprüche, wobei der Steuerschaltkreis bezüglich der elektrochemischen Akkumulatoren galvanisch getrennt und konfiguriert ist, einen Unterbrechungsbefehl an eine Eingangsschnittstelle einer Kontrollvorrichtung zu übertragen, wobei diese letztere Kontrollvorrichtung von einer Stufe der Batterie versorgt wird, die an einen der Pole der Batterie angeschlossen ist.

## Claims

1. Accumulator battery system (1), comprising:
- first and second electrochemical accumulator stages (41, 42) connected in series;
- a first control device (31) supplied with power by way of the potentials across the terminals of at least one accumulator of the first stage (41), configured to measure the potential difference across the terminals of said first stage, comprising a first output interface (312) and a first input interface (311);
- a second control device (32) supplied with power by way of the potentials across the terminals of at least one accumulator of the second stage (42), configured to measure the potential difference across the terminals of said second stage, comprising a second output interface (322), the second control device (32) being configured to apply, to said second output interface, a digital sequence coding the potential difference measured by the second control device;
- a communication circuit (6) configured such that the second output interface (322) communicates via it with said first input interface (311);
**characterized in that** it furthermore comprises:
- a first power supply circuit (313) including a commanded switch (315) configured selectively to apply or to cut off the power supply of said first control device (31), a command interface (314) for commanding the switch (315) being connected to a node (63) of the communication circuit (6) such that maintaining at least one logic level on said second output interface (322) involves applying said power supply to said first control device (31);
- at least one command circuit (317) configured to selectively command the cutting off of the power supply of said first control device (31).

2. System according to Claim 1, wherein:
- the first control device (31) includes an automatic maintenance circuit (316) selectively maintaining an activation signal on said command interface (314);
- said command interface (314) for commanding the switch commands the power supply of said first control device (31) when said logic signal is applied to the second output interface (322) or when the activation signal is applied to this command interface.

3. System according to Claim 2, wherein:
- the communication circuit (6) comprises a voltage divider (64,66) connected between the second output interface (322) and a supply potential of the first control device;
- said command interface (314) for commanding the commanded switch (315) is connected to an intermediate node between the voltage divider and said second output interface;
- said first input interface (311) is connected to an intermediate node of said voltage divider (64,66).

4. System according to Claim 3, wherein:
- said communication circuit (6) includes a DC voltage source (69) and a commanded switch (62) including a command interface, this commanded switch being connected in series with said voltage divider between said DC voltage source (69) and said supply potential of the first control device (31);
- said second output interface (322) being connected to the command interface for commanding the commanded switch (62) of the communication circuit.

5. System according to Claim 4, wherein said DC voltage source is formed of a supply potential of said second control device (32).

6. System according to any one of Claims 2 to 5, wherein said first control device includes a processing circuit (317) configured to selectively command the automatic maintenance circuit (316) to stop maintaining the activation signal on said command interface (314) for commanding said commanded switch of the first power supply circuit.

7. System according to Claim 1, wherein said communication circuit (6) comprises a circuit comprising a first resistor (60) and a commanded switch (62) that are connected in parallel, the latter circuit being connected in series with a second resistor between a supply potential of the second control device and said first input interface, said node (63) of the communication circuit being an intermediate node between the first and second resistors, said second command interface being connected to a command interface for commanding said commanded switch of the communication circuit.

8. System according to Claim 7, wherein said node of the communication circuit is connected to said command interface for commanding the commanded switch of the first power supply circuit.

9. System according to Claim 7 or 8, wherein said communication circuit comprises a third resistor connected in series with the second resistor, said third resistor being connected between said first input interface and a supply potential of said first control device.

10. System according to any one of the preceding claims, furthermore comprising:
- a third accumulator stage connected in series with the first and second stages;
- a third control device supplied with power by way of the potentials across the terminals of at least one accumulator of the third stage, configured to measure the potential difference across the terminals of said third stage, comprising a third output interface and a third input interface, said second control device comprising a second input interface, the third control device being configured to apply, to said third output interface, a digital sequence coding the potential difference measured by the third control device;
- another communication circuit by way of which the third output interface communicates with said second input interface;
- a second power supply circuit (323) including a commanded switch (325) selectively applying or cutting off the power supply of said second control device (32), a command interface (324) for commanding this commanded switch (325) being connected to a node of this other communication circuit such that maintaining at least one logic level on said third output interface involves applying said power supply to said second control device (32).

11. System according to any one of the preceding claims, wherein said command circuit is galvanically isolated with respect to said electrochemical accumulators and is configured to transmit a cutoff command to an input interface of a control device, the latter control device being supplied with power by a stage of the battery, which stage is connected to one of the poles of the battery.
